# EUROPEAN PATENT SPECIFICATION

(11) **EP 2 535 950 B1**
(45) Date of publication and mention of the grant of the patent: **17.10.2018**
(21) Application number: 12001113.5
(22) Date of filing: 20.02.2012
(51) Int. Cl.: H01L 31/05

(54) **Solar cell module**
Solarzellenmodul
Module de cellule solaire

(30) Priority: 14.06.2011 KR 20110057266
(43) Date of publication of application: 19.12.2012
(73) Proprietor: LG Electronics Inc., Yeongdeungpo-gu Seoul 150-721 (KR)
(72) Inventor: Hong, Jongkyoung, Seoul 137-724 (KR); Yu, Jemin, Seoul 137-724 (KR); Kim, Jongdae, Seoul 137-724 (KR)
(74) Representative: Katérle, Axel

(56) References cited:
- WO-A1-2010/122863
- JP-A- 2005 109 415
- KR-B1- 100 929 136
- US-A1- 2010 084 001

## Description

### BACKGROUND OF THE INVENTION

### (a) Field of the Invention

Embodiments of the invention relate to a solar cell module including solar cells electrically connected to each other through an interconnector.

### (b) Description of the Related Art

Solar photovoltaic power generation transforms solar energy to electric energy using a photoelectric transformation effect. Such solar photovoltaic power generation has been used as a mean for obtaining clean and renewable energy. A photoelectric transformation efficiency of a solar cell has been improved dramatically in recent years. Lately, many private houses have been built with a solar photovoltaic power generation system that includes a plurality of solar cell modules.

A solar cell module includes a plurality of solar cells each having a positive electrode part and a negative electrode part connected through an electric conductor in order to output electric power generated by each solar cell. For example, an interconnector is connected with a lead wire to output the generated electric power to the outside of the solar cell module. The lead wire is connected to a junction box, and the generated power is output through a power line of the junction box.

WO 2010/122863 A1 discloses a solar cell module comprising a plurality of solar cells, each including a substrate and an electrode part, an interconnector and a conductive adhesive film disposed between the electrode part and the interconnector, wherein the conductive adhesive resin includes a resin and a plurality of conductive particles.

### SUMMARY OF THE INVENTION

A solar cell module according to the present invention is defined in the claims. In accordance with an embodiment useful for understanding the invention, a solar cell module includes a plurality of solar cells, each soar cell including a substrate and an electrode part formed on the substrate, an interconnector electrically connecting adjacent solar cells, and a conductive adhesive film disposed between the electrode part and the interconnector, and electrically connecting the electrode part with the interconnector. The conductive adhesive film includes a resin and a plurality of conductive particles. The plurality of conductive particles includes a plurality of first particles each including a low melting point metal and a plurality of second particles each including a high melting point metal having a higher melting point than a melting point of the plurality of first particles.

The plurality of second particles may each include at least one metal selected from the group consisting of copper (Cu), silver (Ag), gold (Au), ion (Fe), nickel (Ni), lead (Pb), zinc (Zn), cobalt (Co), titanium (Ti), and magnesium (Mg).

At least one of the plurality of second particles is formed in a radical shape. At least one thickness of the at least one second particle may be about the same with a thickness of the resin or may be thicker than the thickness of the resin.

The plurality of first particles may be included as about 2 volume% to about 10 volume% in a unit volume of the conductive adhesive film, and the plurality of second particles may be included as about 3 volume% to about 15 volume% in the unit volume of the conductive adhesive film.

The plurality of first particles form an interlayer by a metal melted connection with the plurality of second particles.

The interlayer may be a layer that forms an electrical connection in at least one of a width direction, a longitudinal direction and a thickness direction of the conductive adhesive film by the metal melted connection.

The plurality of first particles may include bismuth or a bismuth compound.

The interconnector may include a conductive metal and a solder coated on a surface of the conductive metal. The interlayer may include at least one of SnPbAgBi, SnCuAgBi, SnCuBi, and SnBi.

The electrode part may include silver (Ag). The interlayer may include AgBi.

According to an embodiment of the invention, when the interconnector and the electrode part are bonded using the conductive adhesive film, metal melted connection may be formed between the plurality of conductive particles, between the plurality of conductive particles and the electrode part, and between the plurality conductive particles and the interconnector.

Accordingly, power transfer efficiency may be improved compared to that metal melted connection is not formed.

Furthermore, bonding reliability may be improved because the interconnector and the electrode part are bonded by the metal melted connection in addition to a resin.

Since at least one thickness of the radical shaped second particle is formed thicker than a thickness of the resin, a part of the second particle is absorbed inside the electrode part and/or the interconnector. Accordingly, the current transfer efficiency is further improved by reducing contact resistance.

### BRIEF DESCRIPTION OF THE DRAWINGS

FIG. 1 is a top plan view that illustrates a solar cell module in accordance with an embodiment of the invention.
FIG. 2 is an exploded perspective view of a solar cell module of FIG. 1 in accordance with an embodiment of the invention.
FIG. 3 is a side elevational view of a solar cell module of FIG. 1 in accordance with an embodiment of the invention.
FIG. 4 is an exploded perspective view of a core part of a solar cell module in accordance with an embodiment of the invention.
FIG. 5 is a cross-sectional view of an internal structure of a conductive adhesive film before bonding in accordance with an embodiment of the invention.
FIG. 6 is a schematic cross-section view illustrating assembling of a front surface of a substrate in a solar cell module of FIG. 4 in accordance with an embodiment of the invention.
FIG. 7 is an enlarged view of a particle of FIG. 5 in accordance with an embodiment of the invention.

### DETAILED DESCRIPTION OF THE EMBODIMENTS

In the following detailed description, only certain example embodiments of the invention are shown and described, simply by way of illustration. As those skilled in the art would realize, the described embodiments may be modified in various different ways, all without departing from the spirit or scope of the invention. Accordingly, the drawings and description are to be regarded as illustrative in nature and not restrictive. Like reference numerals designate like elements throughout the specification.

In the drawings, the thicknesses of layers are exaggerated for clarity. It will be understood that when an element such as a layer, film, region or substrate is referred to as being "on" another element, it can be directly on the another element or intervening elements may also be present. In contrast, when an element is referred to as being "directly on" another element, there are no intervening elements present.

Additionally, when an element is referred to as being "formed entirely on" another element, it can be formed on an entire surface of the another element or it can be formed except for edges of the another element.

Hereinafter, embodiments of the invention will be described with reference to the accompanying drawings.

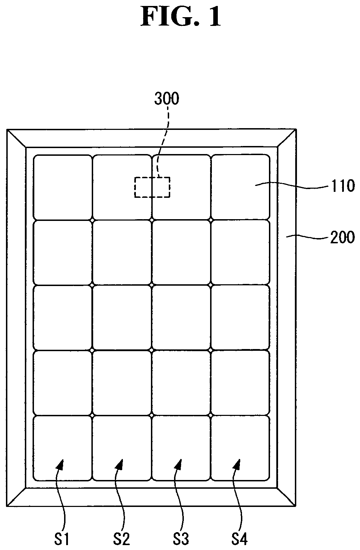

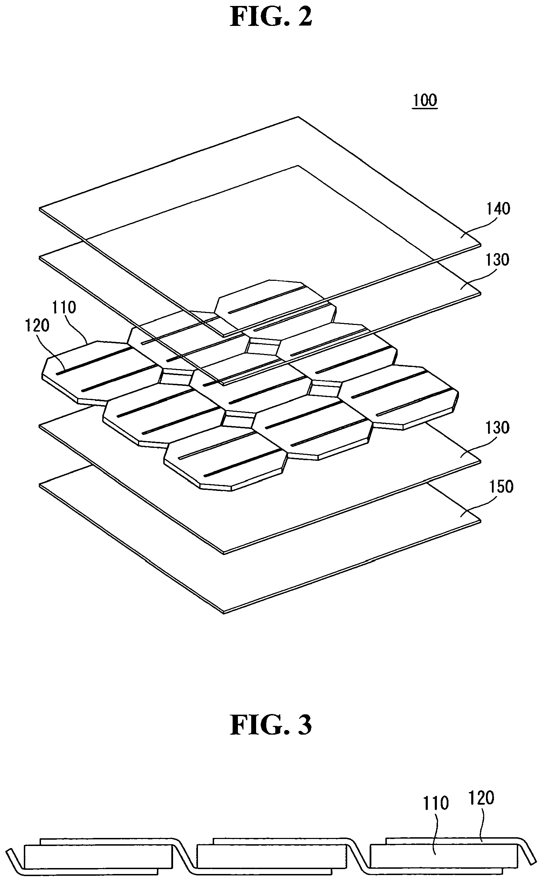

FIG. 1 is a top plan view that illustrates a solar cell module in accordance with an embodiment of the invention. FIG. 2 is an exploded perspective view of a solar cell module of FIG. 1 in accordance with an embodiment of the invention. FIG. 3 is a side elevational view of a solar cell module of FIG. 1 in accordance with an embodiment of the invention.

Referring to FIG. 1 to FIG. 3, a solar cell module 100 may include a plurality of solar cells 110, interconnectors 120, panels formed of ethylene vinyl acetate (EVA) 130, a transparent member 140, and a back sheet 150. The interconnectors 120 may electrically connect adjacent solar cells. The EVA 130 may protect the plurality of solar cells 110. The transparent member 140 may be disposed on the EVA 130. For example, the transparent member 140 may be disposed on a light receiving side of the solar cells 110. The back sheet 150 may be made of an opaque material and disposed on a bottom side of the EVA 130. For example, the bottom side may be opposite to the light receiving side of the solar cells 110.

The solar cell module 110 may further include a frame 200 and a junction box 300. The frame 200 may be integrally formed by a lamination process and house the aforementioned parts of the solar cell module 100. The junction box 300 may collect electric power generated by the solar cells 110.

The back sheet 150 may protect the solar cells 110 from the external environment by preventing moisture from penetrating through a back side of the solar cell module 100. Such a back sheet 150 may have a multi-layer structure including a layer for preventing penetration of moisture and oxygen, a layer for preventing chemical corrosion, and a layer having an insulation characteristic.

The EVA 130 may be disposed on a top side (the light receiving side) and a bottom side (opposite side to the light receiving side) of the solar cells 110 and integrally formed with the solar cells 110. The EVA 130 may prevent the solar cells 110 from corrosion caused by moisture and damage from impacts. Although made of ethylene vinyl acetate, the EVA 130 may be formed of another material, in which instance, it can be referred to as a panel 130.

The transparent member 140 may be disposed on the EVA 130. Such a transparent member 140 may be made of a tempered glass which has a high penetration ratio and which can prevent damage to the solar cell. The tempered glass may be a low iron tempered glass having low iron content. The tempered glass may have an embossed inner side in order to improve a light scattering effect.

Hereinafter, an electric connection structure of a solar cell module in accordance with an embodiment of the invention will be described in detail with reference to FIG. 2 and FIG. 3. FIG. 3 includes an enlarged view of a gap between the solar cells 110. However, the gap between adjacent solar cells may be about 3mm in an embodiment of the invention.

The plurality of solar cells 110 may be arranged in a form of a plurality of strings in the solar cell module 100. The form of the plurality of strings refers to a plurality of solar cells that are arranged in a line and electrically connected with each other. As shown in FIG. 1, the solar cells 100 may be arranged in four strings, for example, a first string to a fourth string S1 to S4.

The plurality of solar cells 110 arranged in each string S1 to S4 may be electrically connected by the interconnectors 120.

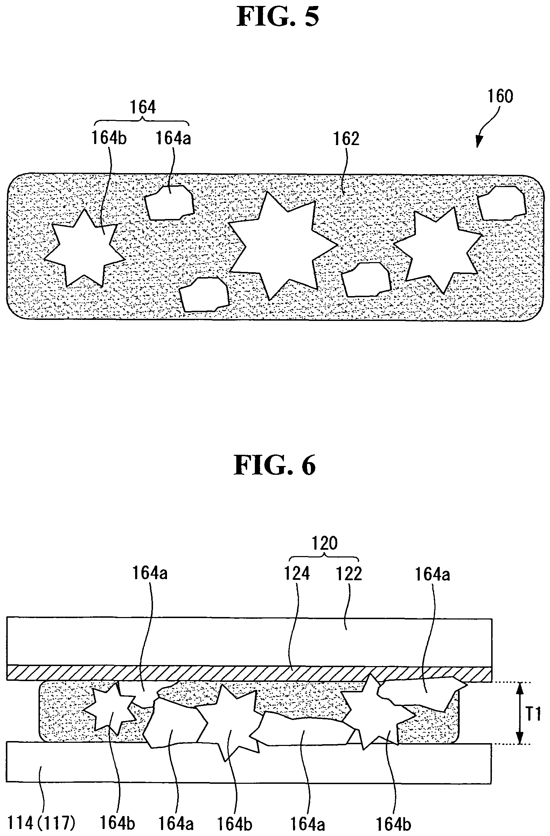

Each interconnector 120 includes a conductive metal 122 and a solder 124 coated on a surface of the conductive metal 122, as shown in FIG. 6. Alternatively, in an example not covered by the invention, the interconnectors 120 may be made of only the conductive metal 122.

The solar cells 110 may be arranged in a longitudinal direction within one string, for example, the first string S1. In such a first string S1, a first electrode current collector 114 of at least one solar cell may be electrically connected to a second electrode current collector 117 of an adjacent solar cell through the interconnector 120.

A lead wire may be connected to an interconnector disposed at one end of an adjacent string may include a conductive metal and a solder like the interconnector 120 or may be formed of only the conductive metal.

Hereafter, a coupling structure between the interconnector and an electrode of a solar cell will be described, in detail, with reference to the accompanying drawings.

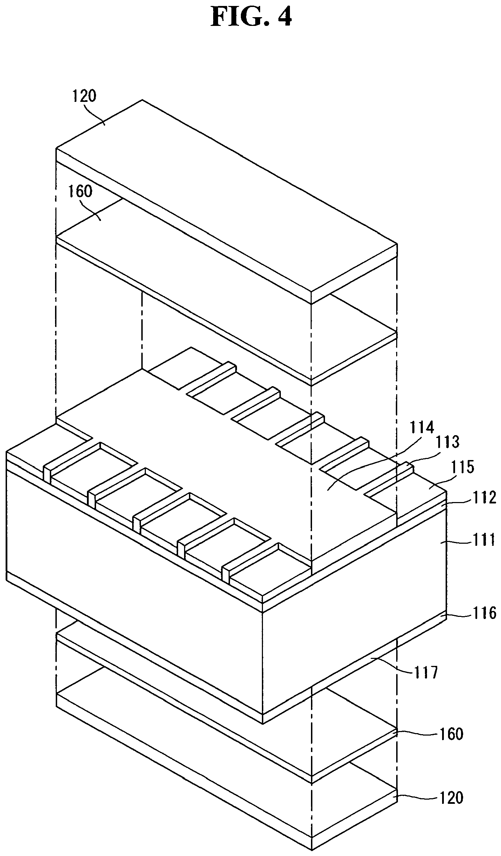

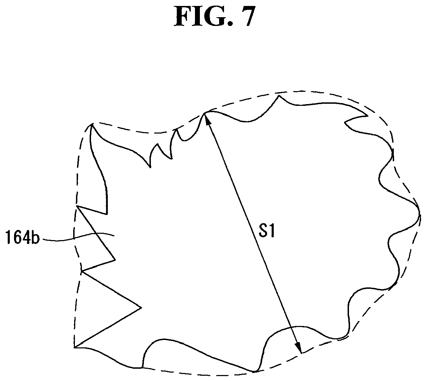

FIG. 4 is an exploded perspective view of a core part of a solar cell module in accordance with an embodiment of the invention. FIG. 5 is a cross-sectional view of an internal structure of a conductive adhesive film before bonding in accordance with an embodiment of the invention. FIG. 6 is a schematic cross-sectional view illustrating assembly of a front surface of a substrate in a solar cell module of FIG. 4 in accordance with an embodiment of the invention. FIG. 7 is an enlarged view of a particle of FIG. 5 in accordance with an embodiment of the invention.

The solar cell 110 in accordance with an embodiment of the invention may include a substrate 111, an emitter 112, a plurality of first electrodes 113, a plurality of first electrode current collectors 114, an antireflection layer 115, a second electrode 116, and a plurality of second electrode current collector 117. The emitter 112 may be disposed on a first surface of the substrate 111. The first surface may be a front surface that receives a solar light. The plurality of first electrodes 113 may be disposed on the emitter 112. The plurality of first electrode current collectors 114 may be disposed to intersect the plurality of first electrodes 113, respectively. The antireflection layer 115 may be disposed on a surface of the emitter 112, where the first electrodes 113 and the first electrode current collectors 114 are not disposed. The second electrode 116 and the second electrode current collector 117 may be disposed on a second surface of the substrate 11. The second surface may be a back surface of the substrate 111, which is opposite to the first surface.

In this instance, the plurality of first electrodes 113 and the plurality of first electrode current collectors 114 form a first electrode part, and a second electrode 116, and the plurality of second electrode current collectors 117 form a second electrode part.

The solar cell may further include a back surface field (BSF) unit formed between the second electrode 116 and the substrate 111. The BSF unit may be a region doped with an impurity at a high concentration. The impurity of the BSF unit may have the same conductive type as an impurity of the substrate 111. For example, the back surface field (BSF) unit may be a p+ region.

Such a BSF unit may function as a potential barrier at the back surface of the substrate 111. Accordingly, the BSF unit may suppress electron-hole recombination at the back side of the substrate 111, thereby improving the efficiency of the solar cell 110.

The substrate 111 may be a semiconductor substrate made of a first conductive type silicon. The first conductive type silicon may be a p-conductive type silicon. The silicon may be a single crystalline silicon, polycrystalline silicon, or amorphous silicon. When the substrate 111 has a p-conductive type, the substrate 111 may contain a Group III element such as boron (B), gallium (Ga), and indium (In).

A surface of the substrate 111 may be textured in order to form a textured surface on the substrate 111.

The textured surface of the substrate 111 may reduce an optical reflectivity of a light receiving surface of the substrate 111. Furthermore, the textured surface of the substrate 111 may increase a light absorbing rate because light may be trapped inside the solar cell by a light incident operation and a light reflecting operation made by the textured surface.

Therefore, the efficiency of the solar cell may be improved. In addition, reflection loss of light entering into the substrate 111 may be reduced, thereby further increasing an amount of light entering into the substrate 111.

The emitter 112 may be a region doped with an impurity of a second conductive type. The impurity of the second conductive type may be opposite to the impurity of the first conductive type of the substrate 111. For example, the second conductive type may be an n-conductive type. The emitter 112 may form a p-n junction with the substrate 111.

When the emitter 112 is an n-conductive type, the emitter 112 may be formed by doping a Group V element such as phosphorus (P), arsenic (As), and antimony (Sb).

Accordingly, when electron-hole pairs are generated inside the semiconductor by light entering to the substrate 111, the electrons moves toward an n-type semiconductor and the holes moves toward a p-type semiconductor. Therefore, when the substrate 111 is a p-conductive type and the emitter 112 is an n-conductive type, holes may move toward the substrate 111 and electrons may move toward the emitter 112.

In other embodiments of the invention, the substrate 111 may be an n-conductive type and be made of another semiconductor material instead of silicon. When the substrate 111 has an n-conductive type, the substrate may contain a Group V element such as phosphorus (P), arsenic (As), and antimony (Sb).

Since the emitter 112 forms a p-n junction with the substrate 111, the emitter 112 may have a p-conductive type when the substrate 111 has an n-conductive type. In this instance, electrons may move toward the substrate 111 and holes may move toward the emitter 112. Thus, when the emitter 112 has a p-conductive type, the emitter 112 may be formed by doping the Group III element such as boron (B), gallium (Ga), and indium (In) to the substrate 111.

The antireflection layer 115 may be formed on the emitter 112 of the substrate 111. The antireflection layer 115 may include a silicon nitride layer (SiNx), a silicon oxide layer (SiO₂), or a titanium dioxide layer (TiO₂). The antireflection layer 115 may reduce reflectivity of light entering the solar cell 111 and increase a selectivity of a specific wavelength region or band of energy, thereby improving the efficiency of the solar cell 110. Such an antireflection layer 115 may have a thickness of about 70nm to about 80nm. The antireflection layer 115 may be omitted in other embodiments of the invention.

The plurality of first electrodes 113 may be referred to as a finger electrode. The plurality of first electrodes 113 may be formed on the emitter 112 and electrically connected to the emitter 112. The plurality of first electrodes 113 may be formed in one direction and be separated from an adjacent first electrode by a predetermined gap. Each first electrode 113 may collect electric charges moving toward the emitter 112. For example, each first electrode 113 may collect electrons.

The plurality of first electrodes 113 may be made of at least one conductive material selected from a group consisting of nickel (Ni), copper (Cu), silver (Ag), aluminum (Al), tin (Sn), zinc (Zn), indium (In), titanium (Ti), gold (Au), and a combination thereof. However, the plurality of first electrodes 113 may be made of another conductive material.

For example, the first electrode 113 may be made of a silver (Ag) paste. In this instance, the silver paste may be coated on the antireflection layer 115 using a screen print process, for example, and the substrate 111 may be processed by performing a firing process at temperatures of about 750°C to about 800°C. As a result, the first electrode 113 is formed and electrically connected to the emitter 112.

In the firing process, etching component included in the silver paste may etch the antireflection layer 115, and the silver paste may come to contact the emitter 112 so as to form the electric connection between the first electrode 113 and the emitter 112. The etching component may be lead oxide.

At least two first electrode current collectors 114 may be formed on the emitter 112 of the substrate 111 in a direction crossing the first electrode 113.

The first electrode current collector 114 may be made of at least one conductive material. The first electrode current collector 114 may electrically and physically connect the emitter 112 and the first electrode 113. Accordingly, the first electrode current collector 114 may output electric charges transferred from the first electrode 113 to an external device. For example, the first electrode current collector 114 may output electrons to the external device.

The conductive metal material of the first electrode current collector 114 may be at least one conductive material selected from a group consisting of nickel (Ni), copper (Cu), silver (Ag), aluminum (Al), tin (Sn), zinc (Zn), indium (In), titanium (Ti), gold (Au), and a combination thereof. However, the plurality of first electrode current collector 114 may be made of another conductive material.

Like the first electrode 113, the first electrode current collector 114 may be formed by coating a conductive metal material (such as a paste) on the antireflection layer 115 and patterning the coated conductive metal material. Then, a firing process may be carried out. The first electrode current collector 114 may be electrically connected to the emitter 112 by the firing process.

A surface of the first electrode current collector 114 may be an uneven surface having a plurality of concaves and convexes. Furthermore, the surface of the first electrode current collector 114 may be an even surface. The first electrode 113 or the first electrode current collector 114 may also have an uneven surface or an even surface in various embodiments of the invention.

The second electrode 116 may be formed on a second surface of the substrate. The second surface may be a back surface of the substrate 111. The second electrode 116 may collect electric charges moving toward the substrate 111. For example, the second electrode 116 may collect holes.

The second electrode 116 may be formed on the entire second surface of the substrate 111. Alternatively, the second electrode 116 may be formed on the second surface of the substrate 111 except edges thereof, or formed on the second surface except a region where the second electrode current collector 117 is disposed.

The second electrode 116 may be made of at least one conductive material. The conductive material may be one selected from a group consisting of nickel (Ni), copper (Cu), silver (Ag), aluminum (Al), tin (Sn), zinc (Zn), indium (In), titanium (Ti), gold (Au), and a combination thereof. However, the second electrodes 116 may be made of another conductive material.

The plurality of second electrode current collectors 117 may be disposed on the same side where the second electrode 116 is formed. The plurality of second electrode current collectors 117 may be formed in a direction crossing the first electrode 113. That is, the plurality of second electrode current collectors 117 may be formed in as same direction of the plurality of first electrode current collectors 114.

The second electrode current collector 117 may be made of at least one conductive material and be electrically connected to the second electrode 116. Accordingly, the second electrode current collector 117 may output electric charges transferred from the second electrode 116. For example, the second electrode current collector 117 may output holes to an external device.

The conductive metal material of the second electrode current collector 117 may be one selected from a group consisting of nickel (Ni), copper (Cu), silver (Ag), aluminum (Al), tin (Sn), zinc (Zn), indium (In), titanium (Ti), gold (Au), and a combination thereof. However, the plurality of second electrode current collector 117 may be made of another conductive material.

The conductive adhesive film 160 may be disposed on the first electrode current collector 114, which is on the emitter 112 of the substrate 111, in a direction parallel to the first electrode current collector 114. Furthermore, the conductive adhesive film 160 may be disposed on the second electrode current collector 117 of the substrate 111.

FIG. 4 illustrates one conductive adhesive film 160 being disposed on each one of the front surface and the back surface of the substrate 111, respectively. However, a plurality of conductive adhesive films 160 may be respectively disposed on the front surface and the back surface as many as the number of the interconnectors 120.

The conductive adhesive film 160 may include a resin 162 and conductive particles 164 distributed in the resin 162, as shown in FIG. 5 and FIG. 6. The resin 162 may be material having an adhesive property, but the embodiments of the invention are not limited thereto. For example, the conductive adhesive film 160 may include a thermosetting resin in order to improve adhesion reliability.

The thermosetting resin may be at least one selected from a group consisting of epoxy resin, phenoxy resin, acryl resin, polymide resin, and polycarbonate resin.

The resin 162 may contain a hardener and a hardening accelerator in addition to the thermosetting resin. For example, the resin 162 may contain a silane coupling agent, a titanate coupling agent, and an aluminate coupling agent, in order to improve the adhesive property between the first electrode current collector 114 and the interconnector 120, and between the second electrode current collector 117 and the interconnector 120. The resin 162 may contain a dispersing agent, for example, calcium phosphate and calcium carbonate, in order to improve a dispersing property of the conductive particles 164. The resin 162 may contain a rubber element such as acryl rubber, silicon rubber, and urethane in order to control the modulus of elasticity.

The resin 162 may be formed at a first thickness T1 at a region of overlap with the first electrode current collector 114. A gap between the interconnector 120 and the first electrode current collector 114 may be maintained with the first thickness T1. For example, the first thickness T1 may be about 3*µ*m to about 15*µ*m.

In accordance with an embodiment of the invention, the conductive particles 164 include a plurality of first particles 164a and a plurality of second particles 164b.

The first particle 164a are made of a low melting point metal that is melted at a temperature lower than a hardening temperature of the resin 162. For example, the first particle 164a may be melted at a temperature below about 180°C. The first particle 164a may form a metal melted connection with at least one of the interconnector 120 and the electrodes 114 and 117. Such a low melting point metal may be bismuth (Bi) and bismuth compounds. For example, the bismuth compounds may be Sn-57Bi. Another material may be used.

The second particle 164b may be made of at least one metal selected from a group consisting of copper (Cu), silver (Ag), gold (Au), ion (Fe), nickel (Ni), lead (Pb), zinc (Zn), cobalt (Co), titanium (Ti), and magnesium (Mg). Another material may be used.

The second particle 164b are formed in a radical shape (an uneven shape or a burr shape). At least one thickness S1 of the second particle 164b is thicker than the thickness T1 of the resin 162 of FIG. 6 after bonding.

The radical shape may be a shape of a circular shaped metal particle having a plurality of irregular protrusions on a surface of the metal particle.

The thickness S1 of the second particle 164b may be a shortest diameter among diameters of about a circle (or oval) formed by a virtual line (i.e., dotted line) that connects ends of protrusions formed on the surface of the particle 164B, as shown in FIG. 7.

The second particle 164b may have a larger contact area contacting electrodes and/or interconnectors compared to a second particle that is formed as a metal coated resin particle in a circular shape or an oval shape. Accordingly, contact resistance may be reduced.

Since the first particle 164a are made of a low melting point metal, the first particle 164a may be melted and form the metal melted connection with the second particle 164b by heat applied during a hardening process that is performed for connecting the interconnector 120 and the electrodes 114 and 117 using the conductive adhesive film 160. Subsequent to the melting, the first particles 164a form an interlayer by way of the metal melted connection by itself and/or together with the plurality of second particles. In embodiments of the invention, the interlayer is a layer that forms an electrical connection (or is electrically connected) in at least one of a thickness direction of the conductive adhesive film, a width direction of the conductive adhesive film, and a longitudinal direction of the conductive adhesive film by the metal melted connection. Also, in an embodiment of the invention, the second particle 164b may be made of a high melting point metal having a higher melting point than a melting point of the first particles 164a.

The first particle 164a may also form metal melted connection with the interconnector 120 and/or the electrodes 114 and 117.

Therefore, electric charges collected at the electrodes 114 and 117 may be transferred in a width direction and a thickness direction of the conductive adhesive film 160 by the conductive particles 164a and 164b. Finally, the electric charges may be transferred to the interconnector 120.

Electric charges may be effectively transferred in the width direction and the thickness direction when the first particle 164a is contained at (or comprises) about 2 volume % to about 10 volume % in a unit volume of the conductive adhesive film 160, and the second particle 164b is contained at (or comprises) about 3 volume % to about 15 volume % in the unit volume of the conductive adhesive film 160.

Therefore, the mix proportion of the first particle 164a and the second particles 164b may be determined based on the above described range.

The conductive adhesive film 160 may be bonded with the first electrode current collector 114 in parallel with the first electrode current collector 114 and may be bonded with the second electrode current collector 117 in parallel with the second electrode current collector 117.

A tabbing process may include a pre-bonding step for bonding the conductive adhesive film 160 with the first electrode current collector 114 and a final-bonding step for bonding the conductive adhesive film 160 with the interconnector 120.

When the tabbing process is performed using the conductive adhesive film 160, conditions for the heating temperature and the pressure may be not specifically controlled within a certain range of the heating temperatures and pressures that can form an electric connection and maintain adhesiveness.

For example, the heating temperature in the pre-bonding step may be set up as a temperature lower than about 100°C. The heating temperature in the final-bonding step may be set up as a range of temperatures hardening the resin 162. For example, the range of heating temperatures in the final-bonding step may be from about 140°C to about 180°C.

The pressure in the pre-bonding step may be set up as about 1MPa. The pressure in the final-bonding may be set up within a range of about 2MPa to about 3Mpa, which allows the first electrode current collector 114, the second electrode current collector 117, and the interconnector 120 to be firmly bonded to the conductive adhesive film 160.

The pressure may maintain the first thickness T1 between the first electrode current collector 114 and the interconnector 120. Accordingly, the second particle 164b having the thickness S1 thicker than the first thickness S1 that is to be absorbed inside the current collectors 114 and 117 and/or the interconnector 120.

Heating and pressurizing time of the pre-bonding step may be set up as about 5 second. Heating and pressuring time of the final-bonding step may be as about 10 seconds which is in a range that does not damage or deform the first electrode current collector 114, the second electrode current collector 117, and the interconnector 120.

The interconnector 120 may include a conductive metal 122 and a solder coated on a surface of the conductive metal.

In this instance, the first particle 164b may be melted with the solder so as to form at least one of SnPbAgBi, SnCuAgBi, SnCuBi, and SnBi.

When the current collectors 114 and 117 include silver (Ag), the first particle 164a may be melted with silver Ag so as to form AgBi.

The above described structure may directly deliver electric charges from the first electrode current collector 114 to the interconnector 120 through the first particle 164a and the second particle 164b.

Connection structures of the first electrode current collector 114, the conductive adhesive film 160, and the interconnector 120 were described with reference to FIG. 6. Such connection structures may be identically applied to connection among the second electrode current collector 117, the conductive adhesive film 160, and the interconnector 120.

Meanwhile, line widths of the first electrode current collector, the conductive adhesive film, and the interconnector may be changed.

For example, a line width of the conductive adhesive film 160, a line width of the interconnector 120, and a line width of the first electrode current collector 114 may be formed identically. However, the line width of the conductive adhesive film 160 may be formed to be thicker than that of the interconnector 120 and the first electrode current collector 114.

As described above, the line widths of the first electrode current collector 114, the conductive adhesive film 160, and the interconnector 120 may be changed in various ways.

Although relation only between the line widths of the interconnector 120 and the first electrode current collector 114 based on the line width of the conductive adhesive film 160 was described, such technical configuration may be identically applied to the second electrode current collector 117.

The conductive adhesive film 160 may be used to bond a lead wire (LW) with the interconnector 120.

In the foregoing description, when the interconnector and the electrode part are bonded using the conductive adhesive film, metal melted connection may be formed between the plurality of conductive particles, between the plurality of conductive particles and the electrode part, and between the plurality conductive particles and the interconnector. Thus, bonding reliability may be improved because the interconnector and the electrode part are bonded by the metal melted connection in addition to a resin.

## Claims

1. A solar cell module comprising:
a plurality of solar cells (110), each solar cell including a substrate and an electrode part (114, 117) formed on the substrate;
an interconnector (120) electrically connecting adjacent solar cells; and
a conductive adhesive film (160) disposed between the electrode part and the interconnector, and electrically connecting the electrode part with the interconnector,
wherein the conductive adhesive film includes a resin (162) and an interlayer formed using a plurality of conductive particles (164);
the plurality of conductive particles include a plurality of first particles (164a) each including a low melting point metal that melts at a temperature lower than a hardening temperature of the resin and a plurality of second particles (164b) each including a high melting point metal having a higher melting point than a melting point of the plurality of first particles, and
wherein the plurality of first particles have formed an interlayer by a metal melted connection with the plurality of second particles during a hardening process of the conductive adhesive film,
wherein the interconnector (120) includes a conductive metal (122) and a solder (124),
wherein the electrode part (114, 117) includes silver (Ag),
wherein the plurality of first particles (164a) includes bismuth or a bismuth compound,
wherein the interlayer includes at least one of SnPbAgBi, SnCuAgBi, SnCuBi, SnBi and AgBi, and
wherein at least one of the second particles (164b) is formed in an uneven shape and has at least one thickness which is thicker than a thickness of the resin (162), such that a part of the plurality of second particles (164b) is absorbed inside the electrode part (114, 117) and/or the interconnector (120).

2. The solar cell module of claim 1, wherein the plurality of second particles (164b) each includes at least one metal selected from the group consisting of copper (Cu), silver (Ag), gold (Au), iron (Fe), nickel (Ni), lead (Pb), zinc (Zn), cobalt (Co), titanium (Ti), and magnesium (Mg).

3. The solar cell module of any one of claims 1 to 2, wherein the plurality of first particles (164a) comprise about 2 volume% to about 10 volume% of a unit volume of the conductive adhesive film (162), and the plurality of second particles (164b) comprise about 3 volume% to about 15 volume% of the unit volume of the conductive adhesive film (162).

4. The solar cell module of claim 1, wherein the interlayer is a layer that forms an electrical connection in at least one of a width and a longitudinal direction of the conductive adhesive film by the metal melted connection.

5. The solar cell module of claim 1 or 4, wherein the interlayer is electrically connected to at least one of the interconnector (120) and the electrode part (114, 117).

6. The solar cell module of any one of claims 1, 4 or 5, wherein the interlayer is a layer that forms an electrical connection in at least one of a thickness direction of the conductive adhesive film and a width and a longitudinal direction of the conductive adhesive film by the metal melted connection.

7. The solar cell module of any one of claims 1 to 6, wherein the bismuth compound is Sn-57Bi.

8. The solar cell module of any one of claims 1 to 7, wherein the plurality of first particles (164a) melt at a temperature below about 180°C.

## Patentansprüche

1. Solarzellenmodul umfassend:
eine Mehrzahl von Solarzellen (110), wobei jede Solarzelle ein Substrat und einen Elektrodenteil (114, 117), der auf dem Substrat gebildet ist, enthält;
einen Interkonnektor (120), der benachbarte Solarzellen elektrisch miteinander verbindet; und
einen leitfähigen adhäsiven Film (160), der zwischen dem Elektrodenteil und dem Interkonnektor angeordnet ist und den Elektrodenteil elektronisch mit dem Interkonnektor verbindet,
wobei der leitfähige adhäsive Film ein Harz (162) und eine Zwischenschicht, welche unter Verwendung einer Mehrzahl von leitfähigen Partikeln (164) gebildet ist, enthält;
wobei die Mehrzahl von leitfähigen Partikeln eine Mehrzahl von ersten Partikeln (164a) enthält, welche jeweils ein niedrigschmelzendes Metall aufweisen, welches bei einer Temperatur unterhalb einer Aushärtungstemperatur des Harzes schmilzt, und eine Mehrzahl von zweiten Partikeln (164b) enthält, welche jeweils ein hochschmelzendes Metall mit einem höheren Schmelzpunkt als einem Schmelzpunkt der Mehrzahl von ersten Partikeln aufweisen, und
wobei die Mehrzahl von ersten Partikeln während eines Aushärtungsprozesses des leitfähigen adhäsiven Films eine Zwischenschicht durch eine Metallschmelzverbindung mit der Mehrzahl von zweiten Partikeln gebildet haben,
wobei der Interkonnektor (120) ein leitfähiges Metall (122) und ein Lot (124) enthält,
wobei der Elektrodenteil (114, 117) Silber (Ag) enthält,
wobei die Mehrzahl von ersten Partikeln (164a) Bismut oder eine Bismut-Verbindung enthalten,
wobei die Zwischenschicht mindestens eines von SnPbAgBi, SnCuAgBi, SnCuBi, SnBi und AgBi enthält, und
wobei mindestens einer der zweiten Partikel (164b) mit einer unregelmäßigen Form gebildet ist und mindestens eine Dicke aufweist, welche dicker ist als eine Dicke des Harzes (162), sodass ein Teil der Mehrzahl von zweiten Partikeln (164b) innerhalb des Elektrodenteils (114, 117) und/oder des Interkonnektors (120) absorbiert ist.

2. Solarzellenmodul nach Anspruch 1, wobei die Mehrzahl von zweiten Partikeln (164b) jeweils mindestens ein Metall enthält, ausgewählt aus der Gruppe bestehend aus Kupfer (Cu), Silber (Ag), Gold (Au), Eisen (Fe), Nickel (Ni), Blei (Pb), Zink (Zn), Kobalt (Co), Titan (Ti) und Magnesium (Mg).

3. Solarzellenmodul nach einem beliebigen der Ansprüche 1 bis 2,
wobei die Mehrzahl von ersten Partikeln (164a) etwa 2 Volumenprozent bis etwa 10 Volumenprozent eines Einheitsvolumens des leitfähigen adhäsiven Films (162) umfasst und die Mehrzahl von zweiten Partikeln (164b) etwa 3 Volumenprozent bis etwa 15 Volumenprozent des Einheitsvolumens des leitfähigen adhäsiven Films (162) umfasst.

4. Solarzellenmodul nach Anspruch 1, wobei die Zwischenschicht eine Schicht ist, welche in einer Breitenrichtung oder/und einer Längsrichtung des leitfähigen adhäsiven Films durch die Metallschmelzverbindung eine elektrische Verbindung bildet.

5. Solarzellenmodul nach Anspruch 1 oder 4,
wobei die Zwischenschicht mit dem Interkonnektor (120) oder/und dem Elektrodenteil (114, 117) elektrisch verbunden ist.

6. Solarzellenmodul nach einem beliebigen der Ansprüche 1, 4 oder 5,
wobei die Zwischenschicht eine Schicht ist, welche in einer Dickenrichtung des leitfähigen adhäsiven Films oder/und einer Breitenrichtung und einer Längsrichtung des leitfähigen adhäsiven Films durch die Metallschmelzverbindung eine elektrische Verbindung bildet.

7. Solarzellenmodul nach einem beliebigen der Ansprüche 1 bis 6,
wobei die Bismut-Verbindung Sn-57Bi ist.

8. Solarzellenmodul nach einem beliebigen der Ansprüche 1 bis 7,
wobei die Mehrzahl von ersten Partikeln (164a) bei einer Temperatur unterhalb etwa 180°C schmilzt.

## Revendications

1. Module de cellules solaires comprenant :
une pluralité de cellules solaires (110), chaque cellule solaire comprenant un substrat et une partie électrode (114, 117) formée sur le substrat ;
un interconnecteur (120) connectant électriquement des cellules solaires adjacentes ; et
un film adhésif conducteur (160) disposé entre la partie électrode et l'interconnecteur, et connectant électriquement la partie électrode à l'interconnecteur,
dans lequel le film adhésif conducteur comprend une résine (162) et une couche intermédiaire formée au moyen d'une pluralité de particules conductrices (164) ;
la pluralité de particules conductrices comprend une pluralité de premières particules (164a) comprenant chacune un métal à bas point de fusion qui fond à une température inférieure à la température de durcissement de la résine et une pluralité de secondes particules (164b) comprenant chacune un métal à point de fusion élevé ayant un point de fusion plus élevé que le point de fusion de la pluralité de premières particules, et
dans lequel la pluralité de premières particules ont formé une couche intermédiaire par une connexion en métal fondu avec la pluralité de secondes particules pendant un processus de durcissement du film adhésif conducteur,
dans lequel l'interconnecteur (120) comprend un métal conducteur (122) et une brasure (124),
dans lequel la partie électrode (114, 117) comprend de l'argent (Ag),
dans lequel la pluralité de premières particules (164a) comprennent du bismuth ou un composé de bismuth,
dans lequel l'intercouche comprend au moins un élément parmi le SnPbAgBi, le SnCuAgBi, le SnCuBi, le SnBi et l'AgBi, et
dans lequel au moins l'une des secondes particules (164b) est formée en une forme inégale et a au moins une épaisseur qui est plus épaisse qu'une épaisseur de la résine (162), de telle sorte qu'une partie de la pluralité de secondes particules (164b) est absorbée à l'intérieur de la partie électrode (114, 117) et/ou de l'interconnecteur (120).

2. Module de cellules solaires selon la revendication 1, dans lequel la pluralité de secondes particules (164b) comprennent chacune au moins un métal choisi dans le groupe constitué par le cuivre (Cu), l'argent (Ag), l'or (Au), le fer (Fe), le nickel (Ni), le plomb (Pb), le zinc (Zn), le cobalt (Co), le titane (Ti) et le magnésium (Mg).

3. Module de cellules solaires selon l'une quelconque des revendications 1 à 2, dans lequel la pluralité de premières particules (164a) constitue environ 2 % en volume à environ 10 % en volume d'un volume unitaire du film adhésif conducteur (162), et la pluralité de secondes particules (164b) constitue environ 3 % en volume à environ 15 % en volume du volume unitaire du film adhésif conducteur (162).

4. Module de cellules solaires selon la revendication 1, dans lequel la couche intermédiaire est une couche qui forme une connexion électrique dans au moins une direction parmi la largeur et la direction longitudinale du film adhésif conducteur par la connexion en métal fondu.

5. Module de cellules solaires selon la revendication 1 ou 4, dans lequel la couche intermédiaire est connectée électriquement à l'interconnexion (120) et/ou à la partie électrode (114, 117).

6. Module de cellules solaires selon l'une quelconque des revendications 1, 4 ou 5, dans lequel la couche intermédiaire est une couche qui forme une connexion électrique dans au moins une direction parmi la direction de l'épaisseur du film adhésif conducteur et la largeur et la direction longitudinale du film adhésif conducteur par la connexion en métal fondu.

7. Module de cellules solaires selon l'une quelconque des revendications 1 à 6, dans lequel le composé de bismuth est le Sn-57Bi.

8. Module de cellules solaires selon l'une quelconque des revendications 1 à 7, dans lequel la pluralité de premières particules (164a) fond à une température inférieure à environ 180 °C.
